(19) Europäisches Patentamt
European Patent Office
Office européen des brevets

(11) **EP 4 621 423 A1**

(12) **EUROPEAN PATENT APPLICATION**
published in accordance with Art. 153(4) EPC

(43) Date of publication:
**24.09.2025 Bulletin 2025/39**

(21) Application number: 23890474.2

(22) Date of filing: 17.10.2023

(51) International Patent Classification (IPC):
*G01R 31/12* (2020.01)     *G01R 31/00* (2006.01)
*G06F 18/10* (2023.01)     *G06F 18/213* (2023.01)
*G06F 18/24* (2023.01)     *H02J 3/38* (2006.01)

(52) Cooperative Patent Classification (CPC):
**G01R 31/00; G01R 31/12; G06F 18/10;
G06F 18/213; G06F 18/24; H02J 3/38;** Y04S 10/52

(86) International application number:
**PCT/CN2023/125029**

(87) International publication number:
**WO 2024/104037 (23.05.2024 Gazette 2024/21)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 14.11.2022  CN 202211421377

(71) Applicant: Shanghai Chint Power Systems Co.,
Ltd.
**Shanghai 201614 (CN)**

(72) Inventors:
• YANG, Bo
  **Shanghai 201614 (CN)**
• WANG, Shien
  **Shanghai 201614 (CN)**
• ZHANG, Yulin
  **Shanghai 201614 (CN)**
• ZHOU, Xu
  **Shanghai 201614 (CN)**

(74) Representative: **Petraz, Gilberto Luigi et al**
**GLP S.r.l.
Viale Europa Unita, 171
33100 Udine (IT)**

(54) **DIRECT-CURRENT ARC DETECTION METHOD BASED ON MATHEMATICAL MORPHOLOGY AND MODE RECOGNITION**

(57)     Disclosed are a DC arc detection method based on mathematical morphology and pattern recognition. The method includes: selecting characteristic bands; extracting energy proportions, in each characteristic band, of a basic value component and/or a fluctuation component of an electrical quantity spectrum in an arc fault state and a normal working state; establishing and training an arc detection pattern recognition model; acquiring an electrical quantity of a DC power system in an operating state; extracting the energy proportion, in each characteristic band, of the basic value component or the fluctuation component in the electrical quantity spectrum in the operating state; and inputting the energy proportion in each characteristic band and working state data of the DC power system in the operating state into the arc detection pattern recognition model for determination. According to the present invention, by means of performing mathematical transformation - mathematical morphological calculation on the electrical quantity, the energy proportions of the basic value components or fluctuation components of a plurality of characteristic bands of arc occurrence are extracted from the electrical quantity spectrum and inputted into the arc detection pattern recognition model, so as to determine whether a series arc fault has occurred, which is less affected by the fluctuation of a signal sampling absolute value, and achieves high precision.

EP 4 621 423 A1

Enter arc detection process

Filter current $I$, then followed by fast Fourier transform and normalization

Perform mathematic - morphological operation on the normalized spectrum to extract a fluctuation component and/or basic value component of the spectrum

Calculate energy proportions, in each characteristic band, of the basic value component and/or fluctuation component

Input the energy proportion in each characteristic band and an operating state of the photovoltaic grid-connected inverter into a support vector machine model

If the output of the model meets an arc fault characteristic?

Yes

No

The counter value plus 1

The counter value minus 1 till 0

If the counter value is greater than a threshold 10?

No

End

Yes

Determine an arc fault has occurred for arc fault treatment

End

FIG. 3

**Description**

**TECHNICAL FIELD**

The present invention relates to the field of protection of DC power systems, in particular to a DC arc detection method based on mathematical morphology and pattern recognition.

**BACKGROUND**

In a DC power system, arc faults may be caused by loose plug-in connectors, aged cable materials, etc., while a DC arc is easy to maintain stable combustion, and the heat generated by the combustion can accumulate to produce high temperature of thousands of degrees Celsius, thus causing a fire.

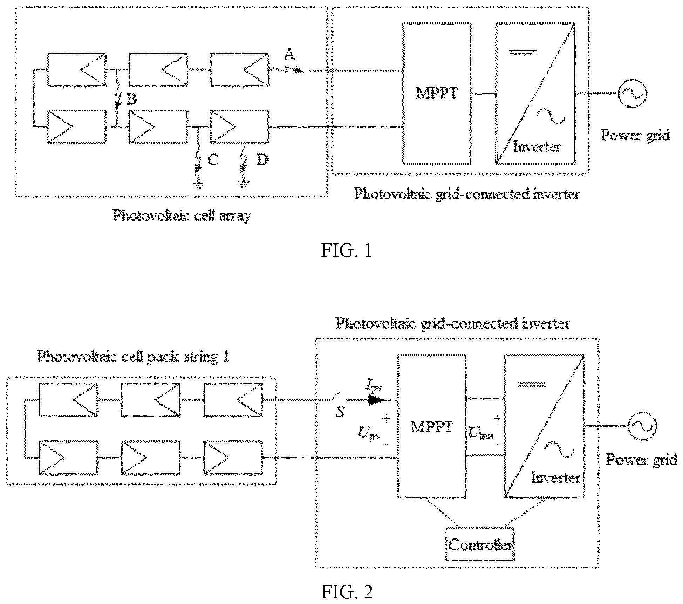

At present, a photovoltaic power generation system is more widely applied in the DC power system, and has a typical structure shown in FIG. 1, which mainly includes a photovoltaic cell array, a photovoltaic grid-connected inverter and a power grid. The photovoltaic cell array typically consists of one or more photovoltaic cell pack strings (only one string is shown in FIG. 1). The photovoltaic grid-connected inverter typically includes one or more MPPT units (only one unit is shown in FIG. 1) and a grid-connected inverter. There are many wiring terminals on a DC side of the photovoltaic power generation system, so arc hazards are likely to occur, which is a key problem affecting the safe operation of the system.

In the photovoltaic power generation system, the fault arcs can be divided into three categories according to different occurrence positions, including series arcs, parallel arcs and ground arcs. In FIG. 1, A represents the series arc within a group, B represents a parallel arc within the group, and C and D are the ground arcs. The parallel arcs and ground arcs are less likely to occur, while the system current increases rapidly during the occurrence process, which can be detected by a current threshold method. However, the probability and frequency of the occurrence of the series arcs are the highest. In a system where the series arcs occur, DC voltage and DC current amplitudes do not change significantly, which makes the detection of the series arcs extremely difficult.

For different physical phenomena, DC arc detection and positioning methods can be divided into methods based on radiation characteristics and methods based on current characteristics. As DC arcs occur, it is usually accompanied by the phenomenon of heating, luminescence, noise and electromagnetic radiation, and then the arc detection based on radiation characteristics can be performed accordingly. However, this type of methods is greatly affected by environmental factors and are usually suitable for confined spaces, while the photovoltaic power generation system is large in scope and usually used outdoors, so this type of methods is not applicable. After the series arcs occur, the arc can be equivalent to a nonlinear time-varying resistor, which creates a disturbance in the current. In the method based on current characteristics, current signals may be collected for a period of time, then subjected to mathematical processing methods such as fast Fourier transform and wavelet transform, and extracted for time-domain characteristics, frequency-domain characteristics and time-frequency domain characteristics. Common time-domain characteristics include variances, peak-to-peak values, change rates, kurtosis, waveform factors, entropy and the like of a current. The effects of the arcs on a spectrum are usually in the range of a few kilohertz to tens of kilohertz. Common frequency-domain characteristics include maximums, energy proportions, variances and the like of characteristic bands. Common time-frequency domain characteristics include energy proportions, singular values, mode maximums, entropy and the like of various wavelets. After characteristic values of current signals are extracted, an arc fault can be determined according to a threshold set in advance and the change of the characteristic value with time. This type of methods is greatly affected by a working state of a photovoltaic inverter, has difficulty to set thresholds, and is thus easy to cause false alarms or missing alarms.

**SUMMARY**

The present invention aims to overcome the defects of the prior art, and to provide a DC arc detection method based on mathematical morphology and pattern recognition. This method has the advantages of less external influence, convenient detection and high accuracy.

In order to achieve the above object, the present invention adopts the following technical solutions:

A DC arc detection method based on mathematical morphology and pattern recognition, comprising the following steps:

S1: establishing a training dataset based on electrical quantities and working state data of a DC power system acquired in both an arc fault state and a normal working state, and establishing and training an arc detection pattern recognition model based on a pattern recognition algorithm and the training dataset;

S2: acquiring an electrical quantity of the DC power system in the operating state;

S3: extracting an energy proportion, in each characteristic band, of a basic value component and/or a fluctuation component in an electrical quantity spectrum in the operating state based on mathematical transformation - mathematical morphological calculation, wherein the mathematical transformation - mathematical morphological calculation comprises the following steps:

a: obtaining an electrical quantity spectrum of the electrical quantities of the DC power system by mathematical transformation;
b: performing a mathematical - morphological operation on the electrical quantity spectrum to obtain the basic value component and/or the fluctuation component;
c: calculating energy proportions, in each characteristic band, of the basic value component and/or the fluctuation component of the spectrum respectively according to the plurality of selected characteristic bands; and

S4: inputting the energy proportions in the operating state into the arc detection pattern recognition model, and determining whether a series arc fault has occurred through the arc detection pattern recognition model.

Preferably, in step S1, the arc detection pattern recognition model is established and trained based on a support vector machine or artificial neural network algorithm and the training dataset.

Preferably, a calculation process of the arc detection pattern recognition model established and trained by the support vector machine based on a linear kernel function is simplified as follows:

$$A^T X + b$$

in which: X represents an input data vector, A represents a coefficient vector with the same dimension as X, and b is a constant.

Preferably, the electrical quantities of the DC power system comprise a DC current, a DC voltage, a component of the DC current or a component of the DC voltage.

Preferably, in step a, the DC component is filtered out before the electrical quantity spectrum is obtained.

Preferably, in step a, an average value of the electrical quantities is calculated first, the DC component is filtered out by subtracting the average value from each electrical quantity, and the electrical quantity spectrum is then obtained by mathematical transformation.

Preferably, in step a, the spectrum is normalized after the electrical quantity spectrum is obtained.

Preferably, in step a, an effective value of the electrical quantity spectrum is calculated, and a normalized spectrum is obtained by dividing a frequency point amplitude by the effective value.

Preferably, in step a, the electrical quantity spectrum is obtained by fast Fourier transform.

Preferably, in step b, the spectrum is processed using mathematical morphological corrosion operation, or dilation operation, or a composite operation of a combination of corrosion operation and dilation operation.

Preferably, in step b, the composite operation of the combination of corrosion operation and dilation operation is performed on the spectrum or normalized spectrum to obtain the basic value component and/or fluctuation component of the spectrum or normalized spectrum.

Preferably, in step S3, 20kHz-28kHz, 36kHz-44kHz and 52kHz-60kHz are selected as characteristic bands for arc occurrence.

Preferably, in step S4, a counter of the arc detection pattern recognition model is set with a threshold; if the calculation result meets an arc fault characteristic, a counter performs accumulative counting; and if a counter value is greater than a threshold, it is determined that an arc fault has occurred in the DC power system.

Preferably, the arc detection pattern recognition model in step S1 is a pre-obtained recognition model; or the step S1 includes: establishing the training dataset based on mathematical transformation - mathematical morphology, and establishing and training the arc detection pattern recognition model based on a pattern recognition algorithm and the training dataset, wherein the training dataset comprises energy proportions in both the arc fault state and the normal working state.

Preferably, in step S1, characteristic values in each characteristic band are calculated and converted based on the energy proportions in each characteristic band, and the training dataset comprises characteristic values in each characteristic band in both the arc fault state and the normal working state; and a calculation formula is as follows:

$$characteristic\ value = ln\left(energy\ proportion\ of\ fluctuation\ component \times \frac{Sum\ of\ squares\ of\ amplitude\ in\ full\ band}{length\ of\ characteristic\ band} + k\right),$$

wherein k is a regulation coefficient.

The arc detection pattern recognition model is established and trained based on mathematical morphology and pattern recognition; by means of performing mathematical transformation-mathematical morphological calculation on the electrical quantities, the energy proportions of basic value components/or fluctuation components of a plurality of characteristic bands of arc occurrence are extracted from the electrical quantity spectrum and inputted into the arc detection pattern recognition model, so as to determine whether a series arc fault has occurred. Because the basic value components of the spectrum are removed by mathematical morphology, it is less affected by the fluctuation of a single sampling absolute value. Therefore, the present invention has the advantages of less influence from the outside and high accuracy than the existing detection methods for extracting current signal characteristic values and comparing these characteristic values with thresholds.

In addition, the energy proportion of each characteristic band is converted into a characteristic value of each characteristic band, which is conducive to model calculation and improves the calculation accuracy.

## BRIEF DESCRIPTION OF THE DRAWINGS

FIG. 1 is a schematic diagram of a DC power system in the Background section;
FIG. 2 is a schematic diagram of the DC power system in the present invention;
FIG. 3 is a flowchart of an arc detection algorithm in the present invention;
FIG. 4 is a set of normal current waveform diagrams in which DC current components are filtered out;
FIG. 5 is a set of arc fault current waveform diagrams in which DC current components are filtered out;
FIG. 6 shows spectra of a normal current and a fault current after FFT analysis;
FIG. 7 shows fluctuation component spectra of a normal current and a fault current in a full band; and
FIG. 8 is multiple sets of characteristic value distribution diagrams of a normal current and a fault current in three bands (20kHz-28kHz, 36kHz-44kHz, and 52kHz-60kHz).

## DETAILED DESCRIPTION OF THE INVENTION

The specific embodiments of a DC arc detection method based on mathematical morphology and pattern recognition of the present invention will be further described below with reference to the embodiments given in accompanying diagrams. The DC arc detection method based on mathematical morphology and pattern recognition of the present invention is not limited to the description of the following embodiments.

A DC arc detection method based on mathematical morphology and pattern recognition includes the following steps:

S1: acquiring electrical quantities of a DC power system in both an arc fault state and a normal working state; selecting a plurality of characteristic bands of arc occurrence; extracting energy proportions, in each characteristic band, of a basic value component or a fluctuation component in an electrical quantity spectrum in both the arc fault state and the operating state based on mathematical transformation - mathematical morphological calculation; establishing a training dataset, the training dataset including energy proportions in both the arc fault state and the normal working state; and establishing and training an arc detection pattern recognition model based on a pattern recognition algorithm and the training dataset;

the mathematical transformation - mathematical morphological calculation including the following steps:

a: obtaining an electrical quantity spectrum of the electrical quantities of the DC power system by mathematical transformation;
b: performing a mathematical morphological operation on the electrical quantity spectrum to obtain the basic value component and/or the fluctuation component; and
c: calculating energy proportions, in each characteristic band, of the basic value component and/or fluctuation component of the spectrum respectively according to the plurality of selected characteristic bands;

S2: acquiring an electrical quantity of the DC power system in the operating state;
S3: extracting the energy proportion, in each characteristic band, of the basic value component or the fluctuation component in the electrical quantity spectrum in the operating state based on mathematical transformation - mathematical morphological calculation; and
S4: inputting the energy proportion in the operating state into the arc detection pattern recognition model, and determining whether a series arc fault has occurred through the arc detection pattern recognition model. According to the present invention, the arc detection pattern recognition model is established and trained based on mathematical morphology and pattern recognition; by means of performing mathematical transformation - mathematical morphological calculation on the electrical quantities, the energy proportions of basic value components/or fluctuation components of a plurality of characteristic bands of arc occurrence are extracted from the electrical quantity spectrum and inputted into the arc detection pattern recognition model, so as to determine whether a series arc fault has occurred. Because the basic value components of the spectrum are removed by mathematical morphology, it is less affected by the fluctuation of a single sampling absolute value. Therefore, the present invention has the advantages of less influence from the outside and high accuracy than the existing detection methods for extracting current signal characteristic values and comparing these characteristic values with thresholds.

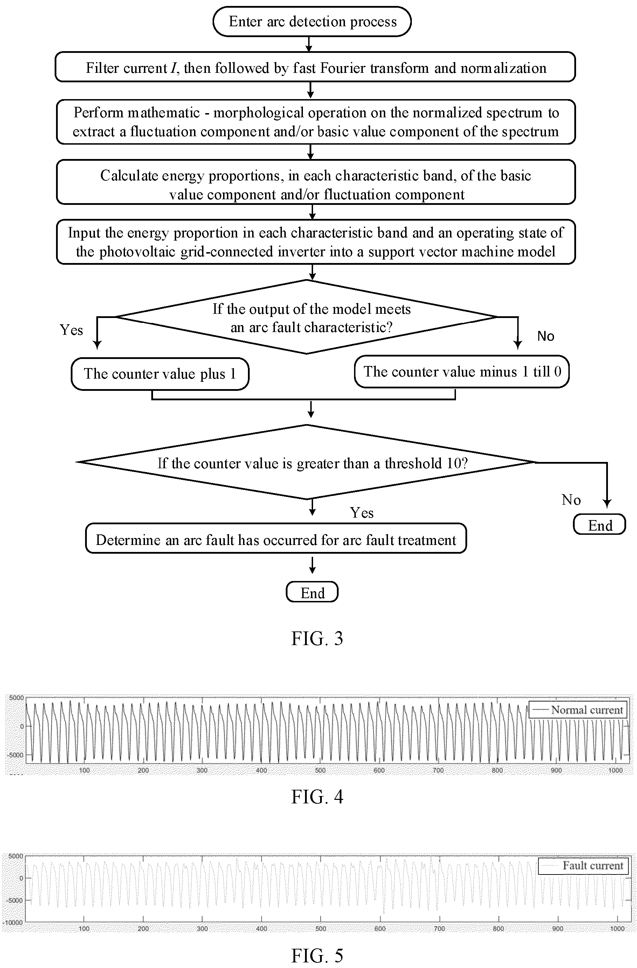

A specific embodiment is provided in conjunction with FIG. 2 and FIG. 3. The present invention may be applied in a photovoltaic power generation system, an energy storage system, a DC microgrid and other fields, and the present embodiment is described by taking a photovoltaic power generation system as an example.

The photovoltaic power generation system mainly includes a photovoltaic cell pack array, a photovoltaic grid-connected inverter and a power grid. The photovoltaic cell array includes one or more photovoltaic cell strings. The photovoltaic grid-connected inverter includes one or more MPPT units and a grid-connected inverter. As shown in FIG. 2, the photovoltaic power generation system of the present embodiment includes a photovoltaic cell pack string and a photovoltaic grid-connected inverter connected to the photovoltaic cell pack string. The photovoltaic grid-connected inverter includes a switch S, an MPPT unit, an inverter and a controller. The switch S is connected between the photovoltaic cell pack string and the MPPT unit. The controller includes a sampling module or a sampling circuit. The electrical quantity data of the photovoltaic grid-connected inverter is collected respectively through the sampling module or the sampling circuit. As the photovoltaic power generation system operates, the switch S of the photovoltaic grid-connected inverter is closed, the controller collects an input current $I_{pv}$ and an input voltage $U_p$ of the MPPT unit, and a voltage $U_{bus}$ outputted to the inverter.

The DC arc detection method based on mathematical morphology and pattern recognition includes the following steps S1-S4.

In S1: firstly, a large number of electrical quantities of the DC power system and working state data of the DC power system in both an arc fault state and a normal working state are collected; then, mathematical transformation-mathematical morphological calculation is performed on the electrical quantities of the DC power system collected in both the arc fault state and the normal working state; the basic value components and/or fluctuation components are extracted from electrical quantity spectra in both the arc fault state and the normal working state; a number of characteristic bands of arc occurrence are selected, and an energy proportion of each characteristic band is calculated;

a training dataset is established, wherein the training dataset includes energy proportions of fluctuation components in both the arc fault state and the normal working state; or the training dataset includes energy proportions of basic components in both the arc fault state and the normal working state; or the training dataset includes energy proportions of fluctuation components and energy proportions of basic components in both the arc fault state and the normal working state; and the training dataset may further include working state data of the DC power system; and finally, an arc detection pattern recognition model is established and trained based on a pattern recognition algorithm and the training dataset, wherein the pattern recognition algorithm may adopt a support vector machine, an artificial neural network and other algorithms. The training dataset is preferably stored in a database, but may also, of course, be stored in an xml text or other ways.

In the present embodiment, the arc detection pattern recognition model is established and trained by a support vector machine based on a linear kernel function to reduce a calculated amount. The calculation process of this model is simplified as follows:

$$A^T X + b$$

in which: X is an input data vector, A is a coefficient vector with the same dimension as X, and b is a constant. Both A and b may be obtained by model training in advance. Specifically, the mathematical transformation - mathematical morphological calculation method includes the following steps a to c.

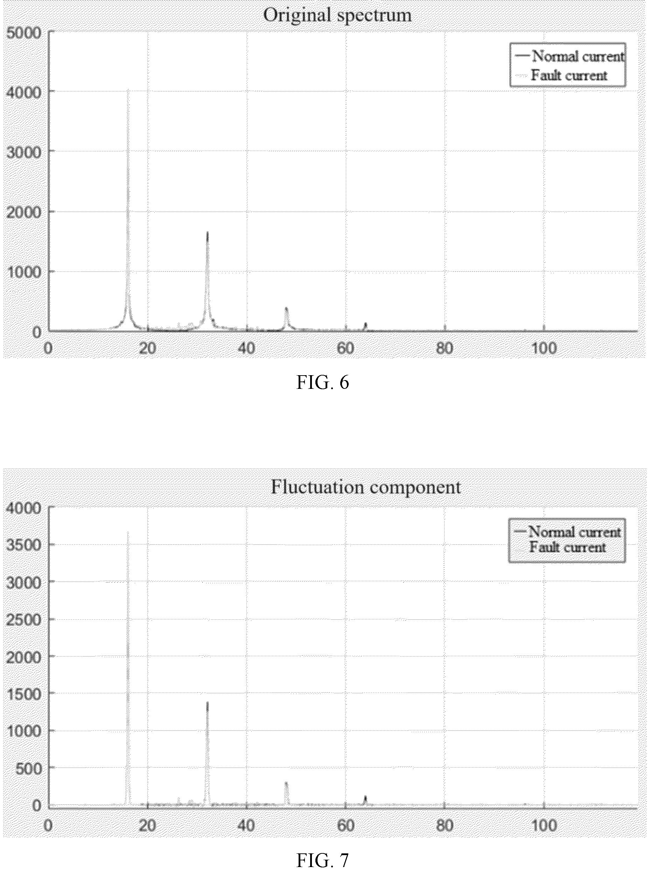

In step a: an electrical quantity spectrum in the arc fault state and an electrical quantity spectrum in the normal working state are obtained correspondingly by performing mathematical transformation (that is, the transformation of the electrical quantities in the time domain and frequency domain) respectively on the electrical quantities in the arc fault state and the electrical quantities in the normal working state, wherein the mathematical transformation is preferably fast Fourier transform. In the present embodiment, the electrical quantity spectrum is denoted by F. In the present embodiment, the spectra of a normal current and a fault current after FFT analysis are shown in FIG. 6.

Preferably, prior to performing the fast Fourier transform, the DC components are filtered out first. The specific process is to solve an average current value $I_{ave}$, and subtract $I_{ave}$ from each collected current value. Of course, it is also possible to omit a step of filtering DC out, as the step of removing a DC component is not necessary, but is beneficial for the signal processing process later.

After an electrical quantity spectrum $F$ is obtained, the spectrum $F$ is preferably normalized. Specifically, an effective value of the spectrum $F$ is calculated, and an amplitude of each frequency point in the spectrum $F$ is divided by the effective value to obtained a normalized spectrum $F_n$. Of course, the spectrum $F$ may also be used directly for the next calculation, but the normalization process is conducive to improving the accuracy of an algorithm.

In step b: the basic value components and/or fluctuation components of the spectrum are obtained by performing mathematical morphological operation on the electrical quantity spectra, the mathematical morphological operation preferably including corrosion operation, dilation operation and a composite operation of a combination of corrosion operation and dilation operation. In the present embodiment, by processing the spectra in both the arc fault state and the normal working state respectively, the basic value components and fluctuation components of the spectra of the DC power system in the two states are obtained accordingly, wherein the spectrum is denoted by $F$, the basic component is denoted by $F_b$, and the fluctuation component is denoted by $F_m$; and a structural element $g(m)=[0,0,0,0,0]^T$ and an offset L are determined for mathematical morphological operation. The corrosion operation and dilation operation are as follows:

$$\text{Corrosion } \Theta: (F_n \Theta g)(n) = min[F_n(n + m - L) - g(m)] \quad m \in 0,1,\dots,M-1;$$

$$\text{Dilation } \oplus: (F_n \oplus g)(n) = max[F_n(n - m + L) + g(m)] \quad m \in 0,1,\dots,M-1.$$

In particular, a specific mathematical morphological operation is provided. In the present embodiment, a flat structural element is preferred as $g(m)=[0,0,0,0,0]^T$, and an offset L as 2;

a corrosion-dilation-dilation-corrosion operation is performed on the normalized spectrum $F_n$ to obtain a spectrum having a basic value component $F_{b1}$:

$$F_{b1} = \left(\left(\left((F_n \Theta g) \oplus g\right) \oplus g\right) \Theta g\right);$$

a dilation-corrosion-corrosion-dilation operation is performed on the normalized spectrum $F_n$ to obtain a spectrum having a basic value component $F_{b2}$:

$$F_{b2} = \left(\left(\left((F_n \oplus g)\Theta g\right)\Theta g\right) \oplus g\right);$$

an average value of the basic components $F_{b1}$ and $F_{b2}$ is taken to remove a dimension, and the normalized spectrum $F_n$ has a basic component $F_b$:

$F_b = 0.5 \cdot (F_{b1} + F_{b2})$ ; and the normalized spectrum $F_n$ has a fluctuation component $F_m$:

$$F_m = F_n - F_b.$$

It should be noted that there are no specific restrictions on the mathematical morphological operations, combination modes and structural elements used. In addition, the above-mentioned mathematical morphological operations may also be performed directly on the spectrum F. The fluctuation components of a normal current and a fault current in a full band, which are obtained in the present embodiment, are shown in FIG. 7. It should be noted that the present embodiment is illustrated by extracting the energy proportion of the fluctuation component in each characteristic band in FIG. 7. As another embodiment, it is also possible to extract the energy proportions of the basic value components. Of course, it is also possible to combine the energy proportions of the basic value components and the energy proportions of the fluctuation components at the same time, and the corresponding training dataset needs to be established at this time.

In step c: the energy proportions, in each characteristic band, of the basic value components and/or fluctuation components of the spectrum are calculated respectively according to the plurality of selected characteristic bands of arc occurrence, and then characteristic values are calculated based on the energy proportion of each characteristic band. That is, the energy proportions of the basic value components and/or the fluctuation components in the arc fault state and the energy proportions of the basic value components and/or the fluctuation components in the normal working state are calculated respectively. In the present embodiment, the energy proportions of the fluctuation components in both the arc fault state and the normal working state are calculated respectively, that is, the training dataset is constructed by the energy proportions of the fluctuation components in both the arc fault state and the normal working state. Of course, the training dataset may also include working state data of the DC power system in these two states.

In the present embodiment, 20kHz-28kHz, 36kHz-44kHz and 52kHz-60kHz are selected as characteristic bands of arc occurrence. However, the characteristic bands of arc occurrence are not limited to the above-mentioned bands, and then the energy proportion of the fluctuation component $F_m$ in each characteristic band is calculated by dividing a sum of squares of spectrum amplitude of a characteristic band by a sum of squares of the entire spectrum.

Preferably, the energy proportion of the fluctuation component in each characteristic band is converted into a characteristic value in each characteristic band, and the training dataset at this time includes characteristic values respectively converted from the energy proportions of the fluctuation components in both the arc fault state and the normal working state, which is conducive to model calculation and improves the accuracy. Of course, it is also possible to directly use the energy proportion in each characteristic band for model training and to determine whether a series arc fault has occurred.

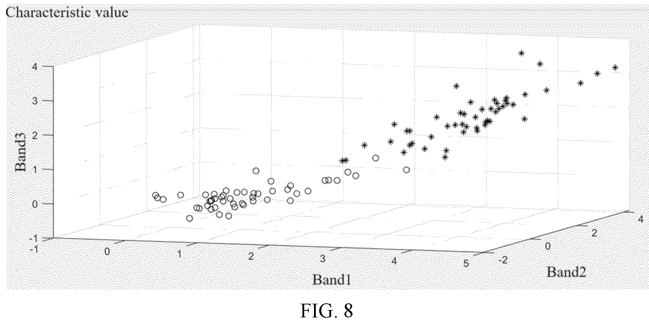

Combined with FIG. 8, the characteristic value distribution of a plurality of sets of normal currents and fault currents in three bands is provided in the present embodiment when the model is established, wherein "O" represents a characteristic value of the normal current, and "*" represents a characteristic value of the fault current. The characteristic value in each band is calculated is as follows:

$$characteristic\ value = ln\left(energy\ proportion\ of\ fluctuation\ component \times \frac{\text{Sum of squares of amplitude in full band}}{\text{length of characteristic band}} + k\right)$$

, wherein k is a regulation coefficient, preferably k is greater than 0, and less than or equal to 0.3, in this embodiment, k = 0.1.

In addition, the training dataset may also include working state data, that is, operation data in both the arc fault state or the normal working state. Specifically, in the present embodiment, the energy proportion in each band, the input current $I_{pv}$ and the input voltage $U_{pv}$ of the MPPT unit, the voltage output $U_{bus}$ outputted to the inverter and other working information of the inverter in the present embodiment are inputted to the arc detection pattern recognition model, and an output of the model is calculated. That is, the working state data in the present embodiment includes the input current $I_{pv}$ and the input voltage $U_{pv}$ of the MPPT unit, and the voltage output $U_{bus}$ outputted to the inverter. The working state data may be different for different electrical apparatuses, or the working state data may also be different for the same electrical apparatus. For example, if the DC power system includes an isolation switch, the training dataset may also include its working state data, and the working state data includes environmental data such as noise generated by the isolation switch during operation. If the DC power system does not include the isolation switch, the working state data of the DC power system only needs to consider a current, a voltage and other data of the apparatus. The working state data may be different for different electrical apparatuses, or the working state data may also be different for the same electrical apparatus.

In step S2: the electrical quantity of the DC power system in the operating state is acquired, that is, an input current *I* of the MPPT unit is collected by the sampling module or sampling circuit of the controller that executes the arc detection pattern recognition model. When the training dataset also includes the working state data, it is also necessary to collect working state data (e.g., environmental data such as noise) of the DC power system in the operating state.

It should be noted that, in the present embodiment, in the normal state, the arc fault state or the operating state, the electrical quantities obtained from the DC power system include DC currents, DC voltages, components in DC currents or components in DC voltages. That is, a signal collected by the sampling module or sampling circuit may be a DC current or a DC voltage, or a portion of components in DC currents or DC voltages, such as high-frequency components or components of a specific band, are collected. In the present embodiment, the effect of the DC voltage is slightly worse than that of the DC current, and the preferably collected signal is the DC current.

In the present embodiment, a normal current waveform diagram is shown in FIG. 4, and an arc fault current waveform diagram is shown in FIG. 5, wherein signal lengths in FIG. 4 and FIG. 5 are each 1,024 signals collected.

In step S3: the energy proportion, in each characteristic band, of the fluctuation component in the electrical quantity spectrum in the operating state is extracted based on mathematical transformation - mathematical morphological calculation in step S1. In step S3 and step S1, if the plurality of selected characteristic bands of arc occurrence is the same, the mathematical transformation-mathematical morphological calculation methods are the same.

Of course, in the modeling process of step S1, when the energy proportion in each characteristic band is converted into the characteristic value in each characteristic band, the energy proportion in each characteristic band in the operating state also needs to be converted into the characteristic value in each characteristic band in step S3.

In step S4: the energy proportion or characteristic value in each characteristic band is inputted into the arc detection pattern recognition model, and whether a series arc fault has occurred is determined through the arc detection pattern recognition model. The key of the present invention is that the energy proportion in each characteristic band needs to be extracted from at least the electrical quantities (or the characteristic values adjusted by the energy proportion in each characteristic band).

In the present embodiment, a counter for the arc detection pattern recognition model is set with a threshold; when the arc detection pattern recognition model determines that an arc fault characteristic is met, the counter performs accumulative counting, and a counter has a value plus 1, otherwise the counter value is reduced until it is 0, that is, the counter has a value minus 1 until it is 0; and if the counter value is greater than a threshold, a series arc fault that has occurred in the DC power system is determined to improve the detection accuracy. For example, in the present embodiment, the threshold is selected as 10. Of course, a threshold may not be set. When the arc detection pattern recognition model determines that an arc fault characteristic is met, the series arc fault is directly considered to have occurred.

**Claims**

1. A DC arc detection method based on mathematical morphology and pattern recognition, comprising the following steps:

   S1: establishing a training dataset based on electrical quantities and working state data of a DC power system acquired in both an arc fault state and a normal working state, and establishing and training an arc detection pattern recognition model based on a pattern recognition algorithm and the training dataset;
   S2: acquiring an electrical quantity of the DC power system in the operating state;
   S3: extracting an energy proportion, in each characteristic band, of a basic value component and/or a fluctuation component in an electrical quantity spectrum in the operating state based on mathematical transformation - mathematical morphological calculation, wherein the mathematical transformation - mathematical morphological calculation comprises the following steps:

      a: obtaining an electrical quantity spectrum of the electrical quantities of the DC power system by mathematical transformation;
      b: performing a mathematical - morphological operation on the electrical quantity spectrum to obtain the basic value component and/or the fluctuation component;
      c: calculating energy proportions, in each characteristic band, of the basic value component and/or the fluctuation component of the spectrum respectively according to the plurality of selected characteristic bands; and

   S4: inputting the energy proportions in the operating state into the arc detection pattern recognition model, and determining whether a series arc fault has occurred through the arc detection pattern recognition model.

2. The DC arc detection method based on mathematical morphology and pattern recognition according to claim 1, wherein in step S1, the arc detection pattern recognition model is established and trained based on a support vector machine or artificial neural network algorithm and the training dataset.

3. The DC arc detection method based on mathematical morphology and pattern recognition according to claim 2, wherein a calculation process of the arc detection pattern recognition model established and trained by the support vector machine based on a linear kernel function is simplified as follows:

$$A^T X + b$$

in which: X represents an input data vector, A represents a coefficient vector with the same dimension as X, and b is a constant.

4. The DC arc detection method based on mathematical morphology and pattern recognition according to claim 1, wherein the electrical quantities of the DC power system comprise a DC current, a DC voltage, a component of the DC current or a component of the DC voltage.

5. The DC arc detection method based on mathematical morphology and pattern recognition according to claim 1, wherein in step a, the DC component is filtered out before the electrical quantity spectrum is obtained.

6. The DC arc detection method based on mathematical morphology and pattern recognition according to claim 5, wherein in step a, an average value of the electrical quantities is calculated first, the DC component is filtered out by subtracting the average value from each electrical quantity, and the electrical quantity spectrum is then obtained by mathematical transformation.

7. The DC arc detection method based on mathematical morphology and pattern recognition according to claim 1, wherein in step a, the spectrum is normalized after the electrical quantity spectrum is obtained.

8. The DC arc detection method based on mathematical morphology and pattern recognition according to claim 7, wherein in step a, an effective value of the electrical quantity spectrum is calculated, and a normalized spectrum is obtained by dividing a frequency point amplitude by the effective value.

9. The DC arc detection method based on mathematical morphology and pattern recognition according to claim 1, 5, 6, 7 or 8, wherein in step a, the electrical quantity spectrum is obtained by fast Fourier transform.

10. The DC arc detection method based on mathematical morphology and pattern recognition according to claim 1, wherein in step b, the spectrum is processed using mathematical morphological corrosion operation, or dilation operation, or a composite operation of a combination of corrosion operation and dilation operation.

11. The DC arc detection method based on mathematical morphology and pattern recognition according to claim 10, wherein in step b, the composite operation of the combination of corrosion operation and dilation operation is performed on the spectrum or normalized spectrum to obtain the basic value component and/or fluctuation component of the spectrum or normalized spectrum.

12. The DC arc detection method based on mathematical morphology and pattern recognition according to claim 1, wherein in step S3, 20kHz-28kHz, 36kHz-44kHz and 52kHz-60kHz are selected as characteristic bands for arc occurrence.

13. The DC arc detection method based on mathematical morphology and pattern recognition according to claim 1, wherein in step S4, a counter of the arc detection pattern recognition model is set with a threshold; if the calculation result meets an arc fault characteristic, a counter performs accumulative counting; and if a counter value is greater than a threshold, it is determined that an arc fault has occurred in the DC power system.

14. The DC arc detection method based on mathematical morphology and pattern recognition according to any one of claims 1 to 13, wherein

    the arc detection pattern recognition model in step S1 is a pre-obtained recognition model; or
    the step S1 includes: establishing the training dataset based on mathematical transformation - mathematical morphology, and establishing and training the arc detection pattern recognition model based on a pattern recognition algorithm and the training dataset, wherein the training dataset comprises energy proportions in both the arc fault state and the normal working state.

15. The DC arc detection method based on mathematical morphology and pattern recognition according to claim 1, wherein

    in step S1, characteristic values in each characteristic band are calculated and converted based on the energy proportions in each characteristic band, and the training dataset comprises characteristic values in each characteristic band in both the arc fault state and the normal working state; and
    a calculation formula is as follows:

$$characteristic\ value = ln\left(energy\ proportion\ of\ fluctuation\ component \times \frac{Sum\ of\ squares\ of\ amplitude\ in\ full\ band}{length\ of\ characteristic\ band} + k\right),$$

    wherein k is a regulation coefficient.

FIG. 1

Photovoltaic cell array

Photovoltaic grid-connected inverter

MPPT

Inverter

Power grid

FIG. 2

Photovoltaic grid-connected inverter

Photovoltaic cell pack string 1

$I_{pv}$

$S$

$U_{pv}$

MPPT

$U_{bus}$

Inverter

Power grid

Controller

Enter arc detection process

Filter current *I*, then followed by fast Fourier transform and normalization

Perform mathematic - morphological operation on the normalized spectrum to extract a fluctuation component and/or basic value component of the spectrum

Calculate energy proportions, in each characteristic band, of the basic value component and/or fluctuation component

Input the energy proportion in each characteristic band and an operating state of the photovoltaic grid-connected inverter into a support vector machine model

If the output of the model meets an arc fault characteristic?

Yes

No

The counter value plus 1

The counter value minus 1 till 0

If the counter value is greater than a threshold 10?

No

End

Yes

Determine an arc fault has occurred for arc fault treatment

End

FIG. 3

FIG. 4

FIG. 5

FIG. 6

FIG. 7

FIG. 8

## INTERNATIONAL SEARCH REPORT

| | International application No. |
|---|---|
| | **PCT/CN2023/125029** |

| | |
|---|---|
| **A.** | **CLASSIFICATION OF SUBJECT MATTER** |

G01R31/12(2020.01)i; G01R31/00(2006.01)i; G06F18/10(2023.01)i; G06F18/213(2023.01)i; G06F18/24(2023.01)i; H02J3/38(2006.01)i

According to International Patent Classification (IPC) or to both national classification and IPC

| | |
|---|---|
| **B.** | **FIELDS SEARCHED** |

Minimum documentation searched (classification system followed by classification symbols)

IPC: G01R G06F H02J

Documentation searched other than minimum documentation to the extent that such documents are included in the fields searched

Electronic data base consulted during the international search (name of data base and, where practicable, search terms used)

CNABS; CNTXT; CNKI; VEN; WOTXT; USTXT; EPTXT; GBTXT; IEEE: 正泰, 杨博, 王世恩, 张玉林, 周旭, 电弧, 直流, 数学形态学, 傅立叶, 傅里叶, 频段, 故障, 能量占比, 波动, arc, direct current, mathematical morphology, FFT, fourier, frequency band, fault, energy fraction, energy ratio, fluctuation

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| PX | CN 115808600 A (CHINT GROUP RESEARCH & DEVELOPMENT CENTER (SHANGHAI) CO., LTD. et al.) 17 March 2023 (2023-03-17) description, paragraphs [0008]-[0092] | 1-15 |
| A | CN 114487689 A (CHINT GROUP RESEARCH & DEVELOPMENT CENTER (SHANGHAI) CO., LTD. et al.) 13 May 2022 (2022-05-13) description, paragraphs [0084]-[0213], and figures 1-9 | 1-15 |
| A | CN 101706527 A (XI'AN JIAOTONG UNIVERSITY) 12 May 2010 (2010-05-12) entire document | 1-15 |
| A | CN 102854426 A (SHAO JUNSONG) 02 January 2013 (2013-01-02) entire document | 1-15 |
| A | CN 113962879 A (STATE GRID HEBEI ELECTRIC POWER CO., LTD., XIONGAN POWER SUPPLY CO., LTD. et al.) 21 January 2022 (2022-01-21) entire document | 1-15 |

| | | | |
|---|---|---|---|
| ✓ Further documents are listed in the continuation of Box C. | | ✓ See patent family annex. | |

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **02 December 2023** | **11 December 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

**C.    DOCUMENTS CONSIDERED TO BE RELEVANT**

| Category* | Citation of document, with indication, where appropriate, of the relevant passages | Relevant to claim No. |
|---|---|---|
| A | US 2018351505 A1 (THE TEXAS A&M UNIVERSITY SYSTEM) 06 December 2018 (2018-12-06) <br> entire document | 1-15 |

Form PCT/ISA/210 (second sheet) (July 2022)

**INTERNATIONAL SEARCH REPORT**
Information on patent family members

International application No.

**PCT/CN2023/125029**

| Patent document cited in search report | | | Publication date (day/month/year) | Patent family member(s) | | | Publication date (day/month/year) |
|---|---|---|---|---|---|---|---|
| CN | 115808600 | A | 17 March 2023 | None | | | |
| CN | 114487689 | A | 13 May 2022 | None | | | |
| CN | 101706527 | A | 12 May 2010 | CN | 101706527 | B | 04 January 2012 |
| CN | 102854426 | A | 02 January 2013 | CN | 102854426 | B | 22 April 2015 |
| CN | 113962879 | A | 21 January 2022 | None | | | |
| US | 2018351505 | A1 | 06 December 2018 | US | 10790779 | B2 | 29 September 2020 |

Form PCT/ISA/210 (patent family annex) (July 2022)